# EUROPEAN PATENT APPLICATION

(11) **EP 4 617 692 A1**
(43) Date of publication of application: **17.09.2025**
(21) Application number: 23895000.0
(22) Date of filing: 21.11.2023
(51) Int. Cl.: G01R 31/392, G01R 31/389, G01R 31/396, G01R 31/382

(54) **SOH PREDICTION DEVICE AND OPERATING METHOD THEREOF**

(30) Priority: 25.11.2022 KR 20220160930; 20.11.2023 KR 20230160489
(71) Applicant: LG Energy Solution, Ltd., Seoul 07335 (KR)
(72) Inventor: KIM, Hyeon Su, Daejeon 34122 (KR); PARK, Jae Dong, Daejeon 34122 (KR)
(74) Representative: Plasseraud IP
(86) International application number: PCT/KR2023/018799
(87) International publication number: WO 2024/112072

(57) **Abstract**

A state of health (SOH) predicting device according to one embodiment disclosed herein includes an electrochemical impedance spectroscopy (EIS) data acquiring unit configured to acquire EIS data of a battery, a feature point identifying unit configured to identify feature points in the EIS data, a resistance parameter calculating unit configured to calculate a resistance parameter of the battery based on the feature points, and an SOH determining unit configured to determine an SOH of the battery according to the resistance parameter from relationship data between temperatures acquired by the EIS data, the resistance parameter, and the SOH.

## Description

### [TECHNICAL FIELD]

### CROSS-REFERENCE TO RELATED APPLICATION

This application claims priority to and the benefit of Korean Patent Applications Nos. 10-2022-0160930 and 10-2023-0160489 filed in the Korean Intellectual Property Office on November 25, 2022 and November 20, 2023, respectively, the entire contents of which are incorporated herein by reference.

### TECHNICAL FIELD

Embodiments disclosed herein relate to a state of health (SOH) predicting device and a method of operating the same.

### [BACKGROUND ART]

Recently, research and development on secondary batteries has been actively conducted. Here, the secondary battery is a battery capable of charging and discharging and includes all recent lithium ion batteries such as conventional Ni/Cd batteries and Ni/MH batteries. Among the secondary batteries, lithium-ion batteries have an advantage of having much higher energy density than conventional Ni/Cd batteries and Ni/MH batteries. In addition, the lithium-ion batteries may be made smaller and lighter and thus are used as a power source for mobile devices and recently, are attracting attention as next-generation energy storage media due to the expansion of the range of usage to a power source for electric vehicles.

A battery exchange system is present as a service related to these secondary batteries. The battery exchange system may provide users with a service that exchanges a discharged battery with a charged battery.

Such a battery exchange system may use a method of measuring a lifetime of a battery used for service. For example, an electrochemical impedance spectroscopy (EIS) may be used as a method for measuring the lifetime of a battery.

### [TECHNICAL PROBLEM]

In order to predict the lifetime of a battery through an electrochemical impedance spectroscopy (EIS), data should be repeatedly collected from various conditions (e.g., a temperature, a state of charge (SOC), and a state of health (SOH)).

However, there is a problem in that collecting EIS data in units of 1 °C is costly and time consuming.

In addition, even when the EIS data is fitted into an equivalent circuit and an SOH is predicted based on the fitted data, the prediction for an actual SOH is not ensured as an actual equivalent circuit is deformed according to the SOH and an SOC.

The objects of embodiments disclosed herein are not limited to the above-described objects, and other objects that are not mentioned will be able to be clearly understood by those skilled in the art from the following descriptions.

### [TECHNICAL SOLUTION]

A state of health (SOH) predicting device according to one embodiment disclosed herein includes an electrochemical impedance spectroscopy (EIS) data acquiring unit configured to acquire EIS data of a battery, a feature point identifying unit configured to identify feature points in the EIS data, a resistance parameter calculating unit configured to calculate a resistance parameter of the battery based on the feature points, and an SOH determining unit configured to determine an SOH of the battery according to the resistance parameter from relationship data between temperatures acquired by the EIS data, the resistance parameter, and the SOH.

According to one embodiment, a first feature point among the feature points may be determined based on a size of a real part of the EIS data.

According to one embodiment, the first feature point among the feature points may represent an impedance with a smallest real part or an impedance in a preset range from the smallest real part in the EIS data.

According to one embodiment, a second feature point among the feature points may be determined based on a size of an imaginary part of the EIS data.

According to one embodiment, the second feature point among the feature points may represent an impedance at a point at which an absolute value of a magnitude of an impedance of the imaginary part is the smallest or an impedance in a preset range from the point at which the absolute value is the smallest in a frequency band of a frequency at which a Warburg impedance appears and a frequency lower than the frequency at which the Warburg impedance appears in the EIS data.

According to one embodiment, the resistance parameter may be determined based on a value obtained by subtracting a value of a real part of a first feature point from a value of a real part of a second feature point among the feature points.

According to one embodiment, the relationship data may be acquired through a comparison between first EIS data of a reference battery acquired at a specified state of charge (SOC), a specified SOH, and specified first temperatures under a specified time condition with second EIS data of the reference battery acquired at the specified SOC, the specified SOH, and specified second temperatures under the specified time condition, and the first temperatures and the second temperatures may be different.

According to one embodiment, the SOH predicting device may include a relationship data generating unit configured to generate equation candidates representing the tendency of the first EIS data, select an equation with a least error among the equation candidates through the second EIS data, and generate relationship data between resistance parameters and SOHs at third temperatures differing from the first temperatures and the second temperatures through the equation with the least error.

According to one embodiment, a temperature range of the first temperatures may include a temperature range of the second temperatures.

A method of operating a state of health (SOH) predicting device according to one embodiment disclosed herein includes an operation of acquiring electrochemical impedance spectroscopy (EIS) data of a battery including at least one battery cell, an operation of identifying feature points in the EIS data, an operation of calculating a resistance parameter of the battery based on the feature points, and an operation of determining an SOH of the battery according to the resistance parameter from relationship data between temperatures acquired by the EIS data, the resistance parameter, and the SOH.

According to one embodiment, a first feature point among the feature points may be determined based on a size of a real part of the EIS data.

According to one embodiment, the first feature point among the feature points may represent an impedance with a smallest real part or an impedance in a preset range from the smallest real part in the EIS data.

According to one embodiment, a second feature point among the feature points may be determined based on a size of an imaginary part of the EIS data.

According to one embodiment, the second feature point among the feature points may represent an impedance at a point at which an absolute value of a magnitude of an impedance of the imaginary part is the smallest or an impedance in a preset range from the point at which the absolute value is the smallest in a frequency band of a frequency at which a Warburg impedance appears and a frequency lower than the frequency at which the Warburg impedance appears in the EIS data.

According to one embodiment, the resistance parameter may be determined based on a value obtained by subtracting a value of a real part of a first feature point from a value of a real part of a second feature point among the feature points.

According to one embodiment, the relationship data may be acquired through a comparison between first EIS data of a reference battery acquired at a specified state of charge (SOC), a specified SOH, and specified first temperatures under a specified time condition with second EIS data of the reference battery acquired at the specified SOC, the specified SOH, and specified second temperatures under the specified time condition, and the first temperatures and the second temperatures may be different.

According to one embodiment, the method of operating the SOH predicting device according to one embodiment may further include an operation of generating equation candidates representing the tendency of the first EIS data, an operation of selecting an equation with a least error among the equation candidates through the second EIS data, and an operation of generating relationship data between resistance parameters and SOHs at third temperatures differing from the first temperatures and the second temperatures through the equation with the least error.

According to one embodiment, a temperature range of the first temperatures may include a temperature range of the second temperatures.

### [ADVANTAGEOUS EFFECTS]

In the SOH predicting device and the method of operating the same according to various embodiments disclosed herein, it is possible to predict the SOH according to the resistance parameter even without collecting the EIS data at all temperatures. Therefore, in the SOH predicting device according to the resistance parameter and the method of operating the same according to various embodiments disclosed herein, it is possible to reduce the cost and the time for collecting the EIS data.

In the SOH predicting device and the method of operating the same according to various embodiments disclosed herein, it is possible to prevent the problem occurring by fitting the EIS data into the equivalent circuit by approximating the resistance parameter through the reform and coordinates of the EIS data.

The effects of the SOH predicting device and the method of operating the same according to the disclosure of the present document are not limited to the above-described effects, and other effects that are not mentioned will be able to be clearly understood by those skilled in the art according to the disclosure of the present document.

### [DESCRIPTION OF DRAWINGS]

FIG. 1 is a block diagram of a state of health (SOH) predicting device according to one embodiment of the present disclosure.
FIG. 2 illustrates an electrochemical impedance spectroscopy (EIS) graph according to one embodiment of the present disclosure.
FIG. 3 illustrates a temperature-resistance parameter graph according to one embodiment of the present disclosure.
FIG. 4 illustrates equations approximating the temperature-resistance parameter graph according to one embodiment of the present disclosure.
FIG. 5 is a flowchart illustrating a method of operating the SOH predicting device according to one embodiment of the present disclosure.
FIG. 6 is a flowchart illustrating the method of operating the SOH predicting device according to one embodiment of the present disclosure.

In the description of the drawings, the same or similar reference numerals may be used for the same or similar components.

### [MODE FOR INVENTION]

Hereinafter, embodiments of the present invention will be described with reference to the accompanying drawings. However, it should be understood that this is not intended to limit the present invention to specific embodiments and includes various modifications, equivalents, and/or alternatives of the embodiments of the present invention.

It should be understood that the embodiments of the present document and the terms used herein are not intended to limit the technical features described herein to specific embodiments and include various modifications, equivalents, or substitutes of the corresponding embodiments. In the description of the drawings, similar reference numerals may be used for similar or related components. The singular form of a noun corresponding to an item may include one item or a plurality of items unless the relevant context clearly dictates otherwise.

In this document, each of phrases such as "A or B," "at least one of A and B," "at least one of A or B," "A, B, or C," "at least one of A, B, and C," and "at least one of A, B, or C" may include any one of the items listed together in the corresponding phrase among these phrases or all possible combinations thereof. Terms such as "first," "second," "first," "second," "A," "B," "(a)," or "(b)" may simply be used to distinguish the corresponding component from another and do not limit the corresponding components in another aspect (e.g., importance or order).

When a certain component (e.g., a first component) is described as being "coupled," "connected," or "joined" to another component (e.g., a second component) with or without the terms "functionally" or "communicatively" or "coupled" or "connected," this means that the certain component may be connected to another component directly (e.g., by wire or wirelessly) or indirectly (e.g., through a third component).

A method according to various embodiments disclosed herein may be provided to be included in a computer program product. The computer program product may be traded between sellers and buyers as commodities. The computer program product may be distributed in the form of a device-readable storage medium (e.g., a compact disc read only memory (CD-ROM)) or distributed (e.g., downloaded or uploaded) through application stores or directly online between two user devices. In the case of the online distribution, at least some of the computer program products may be at least temporarily stored or temporarily generated in a device-readable storage medium such as a memory of a server of a manufacturer, a server of an application store, or a relay server.

According to the embodiments disclosed herein, each component (e.g., a module or a program) of the above-described components may include a single object or a plurality of objects, and some of the plurality of objects may be separately disposed in another component. According to the embodiments disclosed herein, one or more components or operations among the above-described corresponding components may be omitted, or one or more other components or operations may be added. Alternatively or additionally, the plurality of components (e.g., modules or programs) may be integrated into one component. In this case, the integrated component may perform one or more functions of each of the plurality of components identically or similarly to those performed by the corresponding component of the plurality of components before the integration. According to the embodiments disclosed herein, operations performed by modules, programs, or other components may be executed sequentially, in parallel, repeatedly, or heuristically, or one or more of the operations may be executed in a different order or omitted, or one or more other operations may be added.

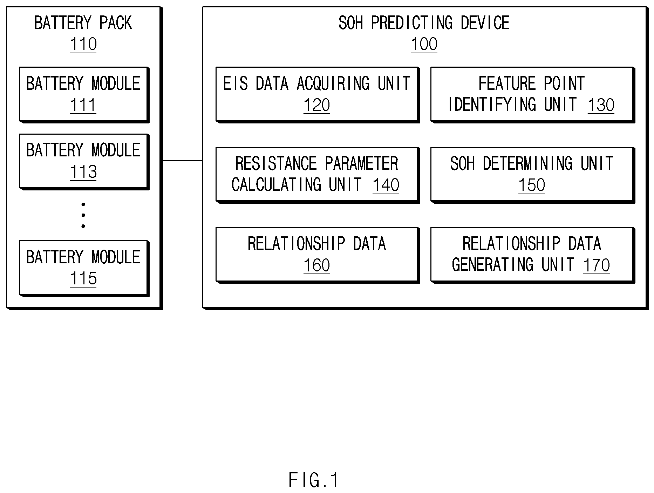

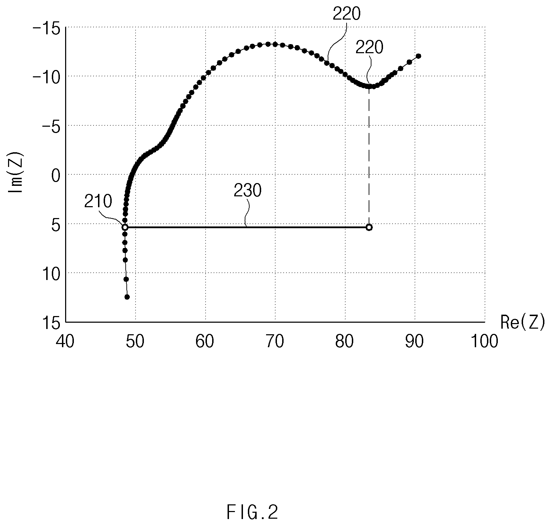

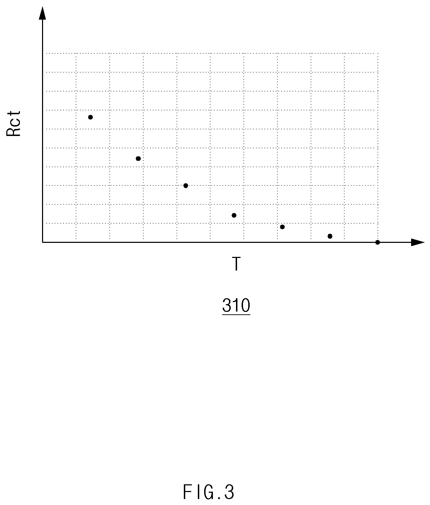

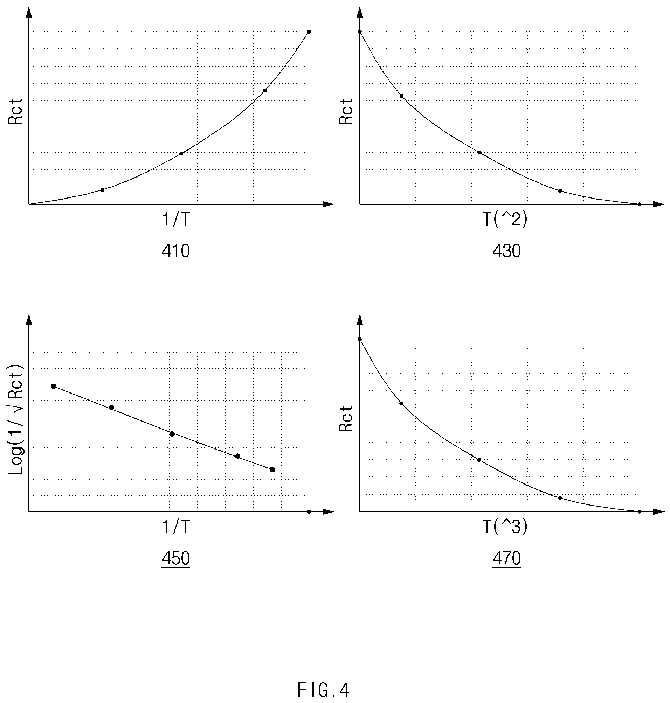

FIG. 1 is a block diagram of a state of health (SOH) predicting device 100 according to a resistance parameter according to one embodiment of the present disclosure. FIG. 2 illustrates an electrochemical impedance spectroscopy (EIS) graph according to one embodiment of the present disclosure. FIG. 3 illustrates a temperature-resistance parameter graph 310 according to one embodiment of the present disclosure. FIG. 4 illustrates equations approximating the temperature-resistance parameter graph according to one embodiment of the present disclosure.

In one embodiment, the SOH predicting device 100 may calculate a resistance parameter of a battery pack 110. In one embodiment, the SOH predicting device 100 may determine a state of health (SOH) of the battery pack 110 based on the resistance parameter of the battery pack 110. Here, the battery pack 110 may include a plurality of battery cells 111, 113, and 115. In one embodiment, the battery pack 110 may be a battery for providing power to two-wheeled electric vehicles (e.g., an electric bike). Here, the two-wheeled electric vehicle may be capable of the replacement of the battery pack 110. Hereinafter, for convenience of description, it is assumed that the resistance parameter of the battery pack 110 is calculated, but the present disclosure is not limited to this example, and the SOH predicting device 100 may be configured to calculate a resistance parameter of a battery module or the like.

In one embodiment, the SOH predicting device 100 may be formed integrally with the battery pack 110. In this case, the SOH predicting device 100 may be included in a battery management system (BMS) of the battery pack 110.

In one embodiment, the SOH predicting device 100 may be formed separately from the battery pack 110. In this case, the SOH predicting device 100 may be included in a battery swapping system (BSS). Here, the BSS may be a system that has a slot into which the battery pack 110 may be inserted and may charge the battery pack 110 through the slot.

In addition, when the SOH predicting device 100 is formed separately from the battery pack 110, the SOH predicting device 100 may be connected to the battery pack 110 via a network (e.g., by wire or wirelessly). In this case, the SOH predicting device 100 may be implemented through a cloud server.

Referring to FIG. 1, the SOH predicting device 100 may include an electrochemical impedance spectroscopy (EIS) data acquiring unit 120, a feature point identifying unit 130, a resistance parameter calculating unit 140, an SOH determining unit 150, relationship data 160, and a relationship data generating unit 170.

In one embodiment, the EIS data acquiring unit 120 may acquire EIS data of the battery. For example, the EIS data acquiring unit 120 may acquire EIS data 200 in units of the battery pack 110, but the present disclosure is not limited to this example. In one embodiment, the EIS data acquiring unit 120 may directly acquire the EIS data by applying a current and/or a voltage to the battery pack 110. In this case, the EIS data acquiring unit 120 may include circuits for applying a current and/or a voltage and a processor for forming the EIS data according to the current and/or the voltage. In one embodiment, the EIS data acquiring unit 120 may indirectly acquire the EIS data from the battery pack 110. For example, the EIS data acquiring unit 120 may receive the EIS data acquired by the battery pack 110. In this case, the EIS data acquiring unit 120 may include a communication circuit capable of wired and/or wireless network communication.

Referring to FIG. 2, the EIS graph may be a graph that coordinates impedances (i.e., the EIS data 220) of the battery pack 110 acquired according to frequencies into a real part and an imaginary part.

In one embodiment, the feature point identifying unit 130 may identify feature points 210 and 220 in the EIS data 200. In one embodiment, the feature point identifying unit 130 may identify two feature points 210 and 220 in the EIS data 200. A first feature point among the feature points may be determined based on a size of the real part of the impedance of the battery pack 110 in the EIS data 200.

According to the embodiment, the first feature point may represent the impedance 210 with the smallest real part or an impedance in a preset range from the impedance 210 with the smallest real part in the EIS data 200. Here, the preset range may be set and changed variously in consideration of an allowable error of the EIS data and the like.

A second feature point among the feature points may be determined based on a size of the imaginary part of the impedance of the battery pack 110 in the EIS data 200.

According to the embodiment, the second feature point may be related to the impedance 220 at a minimum point in the EIS data 200. Alternatively, the second feature point among the feature points may be related to points at which a Warburg impedance is present in the EIS data 200. For example, the second feature point may correspond to an impedance at a point at which an impedance value of the imaginary part is the greatest or an impedance at a point positioned in the preset range from the greatest point in a frequency band corresponding to a frequency at a point at which the Warburg impedance appears and a frequency lower than the frequency 220 at the point at which the Warburg impedance appears. In other words, the second feature point may correspond to an impedance at a point at which an absolute value of a magnitude of the impedance of the imaginary part is the smallest or an impedance at a point positioned in the preset range from the smallest point in the frequency band corresponding to the frequency 220 at which the Warburg impedance appears and the frequency lower than the frequency 220 at which the Warburg impedance appears. Here, the preset range may be set and changed variously in consideration of the allowable error of the EIS data and the like.

In one embodiment, the resistance parameter calculation unit 140 may calculate the resistance parameter of the battery pack 110 based on the feature points 210 and 220. Here, a resistance parameter 230 may be determined based on a value obtained by subtracting a value of the real part of the first feature point 210 from a value of the real part of the second feature point 220. For example, the resistance parameter may be a value obtained by subtracting the value of the real part of the first feature point 210 from the value of the real part of the second feature point 220, or may be determined based on various methods such as rounding or approximating the value obtained by subtracting the value of the real part of the first feature point 210 from the value of the real part of the second feature point 220.

In one embodiment, the SOH determining unit 150 may determine the SOH of the battery pack 110 according to the resistance parameter 230 from the relationship data 160 between temperatures acquired by the EIS data 200, the resistance parameter 230, and the SOH. Here, the temperature may be a temperature at the time of acquiring the EIS data 200 of the battery pack 110. The temperature may be acquired by a temperature sensor (not illustrated) of the SOH predicting device 100 or a temperature sensor (not illustrated) of the battery pack 110.

In one embodiment, the relationship data 160 may be formed as expressed in Table 1 below.

**[Table 1]**

| Temperature | First SOH | ... | N^{th} SOH |
|---|---|---|---|
| 10 | R_{ec10,1} | ... | t_{ct10,N} |
| 11 | R_{ct11,1} | ... | R_{ct11,N} |
| 12 | R_{ct12,1} | ... | t_{ct12,N} |
| ... | ... | ... | ... |
| 44 | R_{ct44,1} | ... | R_{ct44,N} |
| 45 | R_{ct45,1} | ... | R_{ct45,N} |

In Table 1, entries divided by the temperature and the SOH may represent the resistance parameter 230. For example, referring to Table 1, when the temperature of the battery pack 110 is 10 °C and a first SOH is provided, it can be understood that the resistance parameter has R_{ct10,1}. Here, the first SOH may be 100.5865%, and the N^{th} SOH may be 97.338%. In addition, N may be an integer of 2 or more.

For example, when a temperature at which the EIS data 200 has been acquired is 12 °C and the resistance parameter 230 is R_{ct12,1}, the SOH determining unit 150 may determine that a header value (i.e., the first SOH) representing the SOH as the SOH of the battery pack 110 with reference to the relationship data 160 as in Table 1.

Meanwhile, Table 1 is one exemplary embodiment, and a temperature range of the relationship data 160 may be set to include various ranges other than 10 to 45 °C, and an interval between temperatures may also be set to have various intervals other than 1 °C.

As described above, the SOH predicting device 100 may predict the SOH of the battery pack 110 according to the resistance parameter even without collecting the EIS data 200 at all temperatures.

Hereinafter, a method of generating the relationship data 160 by the relationship data generating unit 170 will be described.

In one embodiment, the relationship data generating unit 170 may acquire first EIS data of a reference battery pack at a specified SOC, a specified SOH, and specified first temperatures under a specified time condition. Here, the reference battery pack may be the same type of battery pack as the battery pack 110. According to one embodiment, the specified time condition is an idle time condition and may be a condition with an idle state of the reference battery pack or an opened state of the reference battery pack, but is not limited to this example.

In one embodiment, the relationship data generating unit 170 may calculate resistance parameters at different temperatures based on the first EIS data. Referring to FIG. 3, a graph 310 may represent a temperature-resistance parameter graph based on the first EIS data.

In one embodiment, the relationship data generating unit 170 may generate equation candidates representing the tendency of the first EIS data. In one embodiment, the relationship data generating unit 170 may generate equation candidates representing the temperature-resistance parameter graph based on the first EIS data. For example, the equation candidates may include a first equation expressing the relationship between a reciprocal of a temperature and a resistance parameter, a second equation expressing the relationship between a second-order polynomial about a temperature and the resistance parameter, a third equation expressing the relationship between a third-order polynomial about a temperature and the resistance parameter, and a fourth equation expressing the relationship between a logarithmic value of the reciprocal of the temperature and the reciprocal of the square root of the resistance parameter. For example, referring to FIG. 4, a graph 410 may be a graph according to the first equation, a graph 430 may be a graph according to the second equation, a graph 450 may be a graph according to the third equation, and a graph 470 may be a graph according to the fourth equation.

However, the equations disclosed herein are not limited to this example. For example, the equation candidates may include various equations such as an equation expressing the relationship between an n^{th}-order (n is an integer greater than or equal to 2) polynomial about a temperature and a resistance parameter or an equation expressing the relationship between an n^{th}-order (n is an integer smaller than or equal to -1) polynomial about a temperature and a resistance parameter. In addition, according to the embodiment, n may have not only a positive value or negative value but also a value of a rational number or irrational number. In addition, the equation candidates according to one embodiment disclosed herein may include an equation expressing the relationship between a reciprocal of a temperature and a logarithmic value of a reciprocal of a n^{th} square root of a resistance parameter, an expression expressed as an exponential function or a logarithmic function, and the like. As described above, the equation candidates according to one embodiment disclosed herein may be expressed in various ways as long as they are based on the relationship between a temperature and a resistance parameter.

In one embodiment, the relationship data generating unit 170 may predict the resistance parameter of the reference battery pack at second temperatures using the equation candidates. In one embodiment, the first temperatures and the second temperatures may be different. A temperature range of the first temperatures may include a temperature range of the second temperatures. For example, the first temperatures may be 10, 15, 25, 35, and 45 °C and the second temperatures may be 20, 30, and 40 °C. However, it is illustrative and the embodiments disclosed herein are not limited to this example.

In one embodiment, the relationship data generating unit 170 may select an equation with the least error among the equation candidates through second EIS data. For example, the relationship data generating unit 170 may acquire the second EIS data of the reference battery pack at a specified SOC, a specified SOH, and specified second temperatures under a specified time condition. Then, the relationship data generating unit 170 may calculate resistance parameters at different second temperatures based on the second EIS data. Then, the relationship data generating unit 170 may compare the resistance parameters calculated at the second temperatures with the resistance parameters predicted using the equation candidates. The relationship data generating unit 170 may select an equation candidate with the least error based on a result of the comparison.

In one embodiment, the relationship data generating unit 170 may generate the relationship data 160 between resistance parameters and SOHs at third temperatures differing from the first temperatures and the second temperatures through the equation with the least error. Here, the third temperatures may be temperatures (e.g. temperatures of 11, 12, 13, 14, 41, 42, 43, 44, 45 °C, and the like) not included in the first temperatures and the second temperatures.

Then, the relationship data generating unit 170 may acquire the first EIS data and the second EIS data in a situation in which at least one of the specified SOC and the specified SOH is different and supplement the relationship data 160 based on the acquired first EIS data and second EIS data.

In one embodiment, the relationship data generating unit 170 may acquire the relationship data 160 through the comparison between the first EIS data of the battery pack acquired at the specified SOC, the specified SOH, and the specified first temperatures under the specified time condition with the second EIS data of the battery pack acquired at the specified SOC, the specified SOH, and the specified second temperatures under the specified time condition.

The feature point identifying unit 130, the resistance parameter calculating unit 140, the SOH determining unit 150, and the relationship data generating unit 170 may be implemented as one processor or separate processors. Here, the processor may control one or more other components (e.g., a hardware or software component) of the SOH predicting device 100 by executing software and perform various data processing or calculations. In addition, the relationship data 160 may be stored in a memory (not illustrated) (e.g., a volatile memory and/or a non-volatile memory) of the SOH predicting device 100. In one embodiment, the memory may store data used by at least one component of the SOH predicting device 100. For example, the data may include software (or commands related thereto), input data, or output data. In one embodiment, a command may allow the SOH predicting device 100 to perform operations defined by the command when executed by the processor.

According to the embodiment, the SOH predicting device 100 may transmit the generated relationship data 160 and/or the predicted SOH of the battery pack 110 to an external device (e.g., a cloud server or a user terminal). Here, the cloud server may provide a service for providing the predicted SOH of the battery pack 110 to each of a plurality of users. In addition, the user terminal may include terminals such as personal computers (PC) and smartphones.

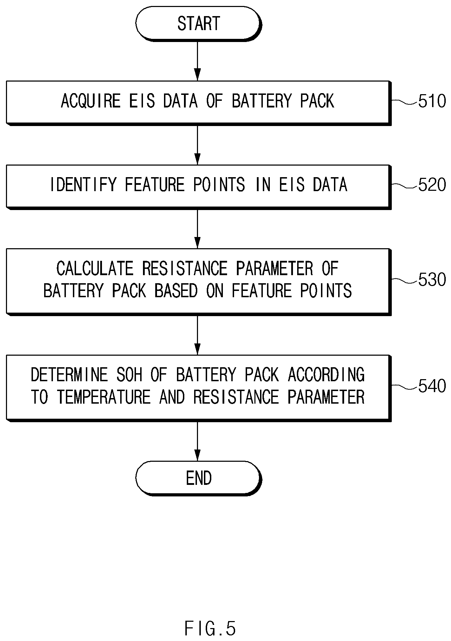

FIG. 5 is a flowchart illustrating a method of operating the SOH predicting device 100 according to the resistance parameter 230 according to one embodiment of the present disclosure.

Referring to FIG. 5, in operation 510, the SOH predicting device 100 may acquire EIS data 510 of the battery pack 110. The EIS graph may be a graph that coordinates the impedances (i.e., the EIS data 220) of the battery pack 110 acquired according to frequencies into the real part and the imaginary part.

In operation 520, the SOH predicting device 100 may identify the feature points 210 and 220 in the EIS data 200. The first feature point among the feature points may be determined based on the size of the real part of the impedance of the battery pack 110 in the EIS data 200. According to the embodiment, the first feature point may represent the impedance 210 with the smallest real part of the impedance of the battery pack 110 or the impedance in the preset range from the impedance 210 with the smallest real part in the EIS data 200. Here, the preset range may be set and changed variously in consideration of the allowable error of the EIS data and the like.

The second feature point among the feature points may be determined based on the size of the imaginary part of the impedance of the battery pack 110 in the EIS data 200.

According to the embodiment, the second feature point may be related to the impedance 220 at a minimum point in the EIS data 200. Alternatively, the second feature point may be related to points at which a Warburg impedance is present in the EIS data 200. For example, the second feature point may correspond to an impedance at a point at which an impedance value of the imaginary part is the greatest or an impedance at a point positioned in the preset range from the greatest point in a frequency band corresponding to a frequency at a point at which the Warburg impedance appears and a frequency lower than the frequency 220 at which the Warburg impedance appears. In other words, the second feature point may correspond to an impedance at a point at which an absolute value of a magnitude of the impedance of the imaginary part is the smallest or an impedance at the point positioned in the preset range from the smallest point in the frequency band corresponding to the frequency 220 at which the Warburg impedance appears and the frequency lower than the frequency 220 at which the Warburg impedance appears.

In operation 530, the SOH predicting device 100 may calculate the resistance parameter 230 of the battery pack based on the feature points 210 and 220. Here, the resistance parameter 230 may be determined based on the value obtained by subtracting the value of the real part of the first feature point 210 from the value of the real part of the second feature point 220. For example, the resistance parameter may be a value obtained by subtracting the value of the real part of the first feature point 210 from the value of the real part of the second feature point 220, or may be determined based on various methods such as rounding or approximating the value obtained by subtracting the value of the real part of the first feature point 210 from the value of the real part of the second feature point 220.

In operation 540, the SOH predicting device 100 may determine the SOH of the battery pack 110 according to the temperature and the resistance parameter 230. In one embodiment, the SOH predicting unit 100 may determine the SOH of the battery pack 110 according to the resistance parameter 230 from the relationship data 160 between temperatures acquired by the EIS data 200, the resistance parameter 230, and the SOH. Here, the temperature may be a temperature at the time of acquiring the EIS data 200 of the battery pack 110.

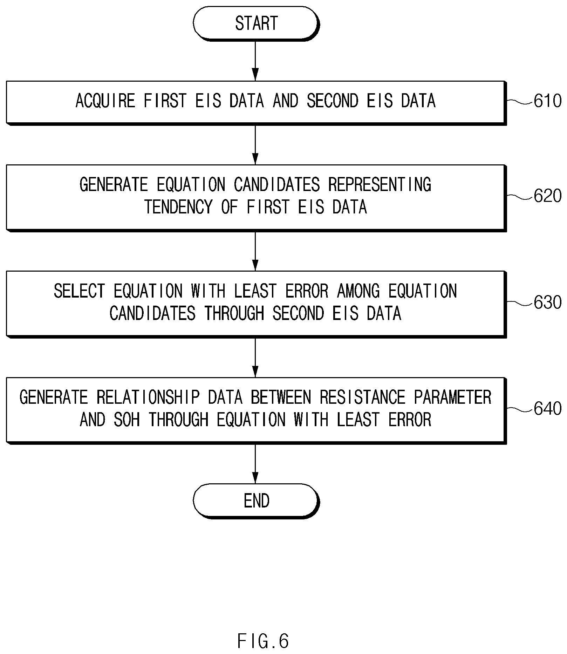

FIG. 6 is a flowchart illustrating a method of operating the SOH predicting device 100 according to the resistance parameter 230 according to one embodiment of the present disclosure.

Referring to FIG. 6, in operation 610, the SOH predicting device 100 may acquire the first EIS data and the second EIS data. For example, the SOH predicting device 100 may acquire the first EIS data of the reference battery pack at the specified SOC, the specified SOH, and the specified first temperatures under the specified time condition. According to one embodiment, the specified time condition is an idle time condition and may be a condition with an idle state of the reference battery pack or an opened state of the reference battery pack, but is not limited to this example. The relationship data generating unit 170 may acquire the second EIS data of the reference battery pack at the specified SOC, the specified SOH, and the specified second temperatures under the specified time condition. Here, the reference battery pack may be the same type of battery pack as the battery pack 110. The temperature range of the first temperatures may include the temperature range of the second temperatures. For example, the first temperatures may be 10, 15, 25, 35, and 45 °C and the second temperatures may be 20, 30, and 40 °C.

In operation S620, the SOH predicting device 100 may generate the equation candidates representing the tendency of the first EIS data. For example, the equation candidates may include the first equation expressing the relationship between the reciprocal of the temperature and the resistance parameter, the second equation expressing the relationship between the second-order polynomial about the temperature and the resistance parameter, the third equation expressing the relationship between the third-order polynomial about the temperature and the resistance parameter, and the fourth equation expressing the relationship between the logarithmic value of the reciprocal of the temperature and the reciprocal of the square root of the resistance parameter.

However, the equations disclosed herein are not limited to this example. For example, the equation candidates may include various equations such as an equation expressing the relationship between an n^{th} (n is an integer greater than or equal to 2) polynomial about a temperature and a resistance parameter or an equation expressing the relationship between an n^{th} (n is an integer smaller than or equal to -1) polynomial about a temperature and a resistance parameter. In addition, according to the embodiment, n may have not only a positive value or negative value but also a value of a rational number or irrational number. In addition, the equation candidates according to one embodiment disclosed herein may include an equation expressing the relationship between a reciprocal of a temperature and a logarithmic value of a reciprocal of an n^{th} square root of a resistance parameter, an expression expressed as an exponential function or a logarithmic function, and the like. As described above, the equation candidates according to one embodiment disclosed herein may be expressed in various ways as long as they are based on the relationship between a temperature and a resistance parameter.

In operation 630, the SOH predicting device 100 may select the equation with the least error among the equation candidates through the second EIS data. For example, the SOH predicting device 100 may predict the resistance parameter of the reference battery pack at the second temperatures using the equation candidates. In addition, the SOH predicting device 100 may calculate the resistance parameters at different second temperatures based on the second EIS data. Then, the SOH predicting device 100 may compare the resistance parameters calculated at the second temperatures with the resistance parameters predicted using the equation candidates. The SOH predicting device 100 may select the equation candidate with the least error based on a result of the comparison.

In operation 640, the SOH predicting device 100 may generate the relationship data between the resistance parameter and the SOH through the equation with the least error. For example, the SOH predicting device 100 may generate the relationship data 160 between the resistance parameters and the SOHs at the third temperatures differing from the first temperatures and the second temperatures through the equation with the least error. Here, the third temperatures may be temperatures (e.g. temperatures of 11, 12, 13, 14, 41, 42, 43, 44, 45 °C, and the like) not included in the first temperatures and the second temperatures.

Then, the SOH predicting device 100 may acquire the first EIS data and the second EIS data in a situation in which at least one of the specified SOC and the specified SOH is different and supplement the relationship data 160 based on the acquired first EIS data and second EIS data.

## Claims

1. A state of health (SOH) predicting device comprising,
an electrochemical impedance spectroscopy (EIS) data acquiring unit configured to acquire EIS data of a battery;
a feature point identifying unit configured to identify feature points in the EIS data;
a resistance parameter calculating unit configured to calculate a resistance parameter of the battery based on the feature points; and
an SOH determining unit configured to determine an SOH of the battery according to the resistance parameter from relationship data between temperatures acquired by the EIS data, the resistance parameter, and the SOH.

2. The SOH predicting device according to claim 1, wherein a first feature point among the feature points is determined based on a size of a real part of the EIS data.

3. The SOH predicting device according to claim 2, wherein the first feature point among the feature points represents an impedance with a smallest real part or an impedance in a preset range from the smallest real part in the EIS data.

4. The SOH predicting device according to claim 1, wherein a second feature point among the feature points is determined based on a size of an imaginary part of the EIS data.

5. The SOH predicting device according to claim 4, wherein the second feature point among the feature points represents an impedance at a point at which an absolute value of a magnitude of an impedance of the imaginary part is the smallest or an impedance in a preset range from the point at which the absolute value is the smallest in a frequency band of a frequency at which a Warburg impedance appears and a frequency lower than the frequency at which the Warburg impedance appears in the EIS data.

6. The SOH predicting device according to claim 1, wherein the resistance parameter is determined based on a value obtained by subtracting a value of a real part of a first feature point from a value of a real part of a second feature point among the feature points.

7. The SOH predicting device according to claim 1, wherein the relationship data is acquired through a comparison between first EIS data of a reference battery acquired at a specified state of charge (SOC), a specified SOH, and specified first temperatures under a specified time condition with second EIS data of the reference battery acquired at the specified SOC, the specified SOH, and specified second temperatures under the specified time condition, and
the first temperatures and the second temperatures are different.

8. The SOH predicting device according to claim 7, comprising a relationship data generating unit configured to generate equation candidates representing the tendency of the first EIS data, select an equation with a least error among the equation candidates through the second EIS data, and generate relationship data between resistance parameters and SOHs at third temperatures differing from the first temperatures and the second temperatures through the equation with the least error.

9. The SOH predicting device according to claim 7, wherein a temperature range of the first temperatures includes a temperature range of the second temperatures.

10. A method of operating a state of health (SOH) predicting device, comprising:
an operation of acquiring electrochemical impedance spectroscopy (EIS) data of a battery including at least one battery cell;
an operation of identifying feature points in the EIS data;
an operation of calculating a resistance parameter of the battery based on the feature points; and
an operation of determining an SOH of the battery according to the resistance parameter from relationship data between temperatures acquired by the EIS data, the resistance parameter, and the SOH.

11. The method according to claim 10, wherein a first feature point among the feature points is determined based on a size of a real part of the EIS data.

12. The method according to claim 11, wherein the first feature point among the feature points represents an impedance with a smallest real part or an impedance in a preset range from the impedance with the smallest real part in the EIS data.

13. The method according to claim 10, wherein a second feature point among the feature points is determined based on a size of an imaginary part of the EIS data.

14. The method according to claim 13, wherein the second feature point among the feature points represents an impedance at a point at which an absolute value of a magnitude of an impedance of the imaginary part is the smallest or an impedance in a preset range from the point at which the absolute value is the smallest in a frequency band of a frequency at which a Warburg impedance appears and a frequency lower than the frequency at which the Warburg impedance appears in the EIS data.

15. The method according to claim 10, wherein the resistance parameter is determined based on a value obtained by subtracting a value of a real part of a first feature point from a value of a real part of a second feature point among the feature points.

16. The method according to claim 10, wherein the relationship data is acquired through a comparison between first EIS data of a reference battery acquired at a specified state of charge (SOC), a specified SOH, and specified first temperatures under a specified time condition with second EIS data of the reference battery acquired at the specified SOC, the specified SOH, and specified second temperatures under the specified time condition, and
the first temperatures and the second temperatures are different.

17. The method according to claim 16, further comprising: an operation of generating equation candidates representing the tendency of the first EIS data;
an operation of selecting an equation with a least error among the equation candidates through the second EIS data; and
an operation of generating relationship data between resistance parameters and SOHs at third temperatures differing from the first temperatures and the second temperatures through the equation with the least error.

18. The method according to claim 16, wherein a temperature range of the first temperatures includes a temperature range of the second temperatures.
